# DEMANDE DE BREVET EUROPEEN

(11) **EP 1 355 425 A2**
(43) Date de publication de la demande: **22.10.2003**
(21) Numéro de dépôt: 03290861.8
(22) Date de dépôt: 07.04.2003
(51) Int. Cl.: H03K 17/96

(54) **Organe de commande de type capacitif**

(30) Priorité: 16.04.2002 FR 0204744
(71) Demandeur: Faurecia Industries, 92000 Nanterre (FR)
(72) Inventeur: Balp, Lionel, 25400 Audincourt (FR); Bocquet, Denis, 90850 Essert (FR); Henigue, Christian, 25400 Audincourt (FR); Roudot, Jean-Luc, 25230 Seloncourt (FR)
(74) Mandataire: Habasque, Etienne Joel Jean-François

(57) **Abrégé**

Cet organe comprend une structure de support (2) présentant une zone de commande (3), ladite zone de commande (3) comportant un trou traversant (4), un revêtement élastique (5) non-conducteur recouvrant une face de commande (6) de la zone de commande (3) au moins en regard du trou traversant (4), un détecteur tactile (7) au moins partiellement en regard du trou traversant (4) et monté sur ou à proximité de la face (8) de la zone de commande (3), opposée à la face de commande (6), le revêtement élastique (5) ayant une position de repos dans laquelle le doigt (9) de l'opérateur au contact de la surface libre (10) du revêtement élastique (5) est hors de l'espace de détection tactile du détecteur (7), et une position déformée, dans laquelle le doigt (9) de l'opérateur au contact de la surface libre (10) du revêtement élastique (5) est dans l'espace de détection tactile du détecteur (7). Selon l'invention, en position de repos le revêtement élastique (5) est écarté du détecteur tactile (7), et position déformée, le revêtement élastique (5) est au contact du détecteur tactile (7).

## Description

La présente invention concerne un organe de commande de type capacitif pour la commande d'au moins un organe fonctionnel notamment de véhicule automobile et une pièce d'équipement de véhicule, comportant un tel organe.

On sait que les pièces d'équipement des véhicules automobiles intègrent en nombre croissant des organes de commande des organes fonctionnels de ces véhicules.

Plusieurs pièces d'équipement disposées dans l'habitacle d'un véhicule reçoivent en effet des organes de commande de ce type, qui sont alors mis à la disposition des utilisateurs du véhicule.

Ces pièces sont par exemple formées par les panneaux de porte, la planche de bord ou encore la console centrale du véhicule, etc...

Ces organes de commande sont, en général, regroupés sur ce que l'on appelle communément des platines qui regroupent différents organes, tels que par exemple des interrupteurs, des commutateurs ou encore des boutons rotatifs intégrés dans les circuits électriques de commande des organes fonctionnels.

Mais l'on conçoit que ces organes présentent un certain nombre d'inconvénients, notamment au niveau de leur encombrement et de leur fiabilité, car ceux-ci mettent en jeu des pièces en mouvement.

Un autre problème lié à l'utilisation de ce type d'organes, réside dans la complexité de leur montage et de leur implantation à bord du véhicule qui nécessite l'utilisation de pièces de fixation (vis, platine, etc ..) et un temps de montage relativement long.

On connaît par ailleurs de façon générale, les détecteurs tactiles.

On pourra par exemple se reporter aux documents FR-A-2 779 889, FR-A-2 737 359, US-A-5 572 205 et US-A-5 270 710.

Le principe de fonctionnement de ces détecteurs consiste à détecter une variation de capacité grâce à une électrode placée par exemple sur une plaque de circuit imprimé sous une zone d'opération de commande, cette variation de capacité étant ensuite analysée et traitée par un circuit électronique permettant de commander une fonction quelconque. En dessous d'un seuil capacitif prédéterminé, la commande n'est pas activée, au-dessus de ce seuil la commande est activée.

Ces détecteurs présentent l'avantage de ne pas nécessiter de pièces en mouvement, mais ils présentent un inconvénient au niveau du retour d'information en particulier tactile vers l'utilisateur.

Ainsi par exemple, avec un système à touches sensitives, tel que décrit dans le document US-A-5 572 205, dans lequel il est prévu un support rigide avec un capteur capacitif sur une face du support et une zone d'opération en regard sur l'autre face de ce support, la sensation d'appuyer sur un bouton n'est pas perçue par l'utilisateur.

Ceci peut être gênant par exemple si l'utilisateur est le conducteur du véhicule qui appuie alors en aveugle sur les organes de commande.

Sans retour d'information tactile, cet utilisateur peut alors être amené à appuyer plusieurs fois sur la zone d'opération au risque de ne pas obtenir la commande souhaitée.

En outre, cela occasionne un problème de concentration sur la conduite du véhicule.

Le document US-A-4 022 296 décrit quant à lui, un boîtier de commande comprenant des interrupteurs de commande capacitifs qui posent également de tels problèmes.

Le document EP-02290167.2 de la demanderesse décrit un organe de commande de type capacitif pour la commande d'au moins un organe fonctionnel notamment de véhicule automobile, comprenant une structure de support rigide, au moins une cellule capacitive de détection tactile localisée sur ou à proximité d'une des faces de ladite structure de support et au moins une zone d'opération de commande localisée sur ou à proximité de l'autre face de ladite structure de support en regard de la cellule capacitive de détection tactile, la zone d'opération de commande comprenant des moyens déformables élastiquement. Ainsi, l'utilisateur perçoit un déplacement quand il appuie sur la zone d'opération. La perception de commande en est grandement améliorée. Dans une forme de réalisation, les moyens déformables élastiquement ont une position de repos dans laquelle le doigt de l'opérateur au contact de la zone d'opération est hors de l'espace de détection tactile et une position déformée dans laquelle le doigt de l'opérateur au contact de la zone d'opération est dans l'espace de détection tactile. Cette caractéristique permet de contrôler avec plus de sécurité le déclenchement de la commande en obligeant l'utilisateur à enfoncer la zone d'opération pour être dans l'espace de détection tactile. On entend par espace de détection tactile l'espace dans lequel le doigt de l'opérateur génère une variation capacitive allant au-delà du seuil capacitif prédéterminé, la commande étant alors activée

L'un des buts de la présente invention est d'apporter de nouvelles améliorations à l'organe de commande de type capacitif ci-dessus décrit, pour augmenter la perception de l'utilisateur et améliorer la sensibilité de l'espace de détection tactile.

A cet effet, l'invention concerne un organe de commande de type capacitif comprenant :
une structure de support présentant une zone de commande, ladite zone de commande comportant un trou traversant,
un revêtement élastique non-conducteur recouvrant une face de commande de la zone de commande au moins en regard du trou traversant,
un détecteur tactile au moins partiellement en regard du trou traversant et monté sur ou à proximité de la face de la zone de commande, opposée à la face de commande, le revêtement élastique ayant une position de repos dans laquelle le doigt de l'opérateur au contact de la surface libre du revêtement élastique est hors de l'espace de détection tactile du détecteur, et une position déformée, dans laquelle le doigt de l'opérateur au contact de la surface libre du revêtement élastique est dans l'espace de détection tactile du détecteur, caractérisé en ce qu'en position de repos, le revêtement élastique est écarté du détecteur tactile, et, en position déformée, le revêtement élastique est au contact du détecteur tactile.

Selon un mode de réalisation de l'invention, le détecteur tactile comprend un circuit imprimé sur lequel est intégrée une électrode de détection tactile au moins partiellement en regard du trou traversant, et le revêtement élastique en position déformée est au contact direct du circuit imprimé

Dans un autre mode de réalisation de l'invention, le détecteur tactile comprend un circuit imprimé sur lequel est intégrée une électrode de détection tactile au moins partiellement en regard du trou traversant, et une pièce de couplage non-conductrice électriquement, au moins partiellement en regard du trou traversant et de l'électrode, ayant une première face montée au contact direct du circuit imprimé, et une seconde face au contact direct du revêtement élastique en position déformée.

Selon une autre caractéristique de ce mode de réalisation, la pièce de couplage comprend un guide de lumière couplé avec au moins une source lumineuse.

Selon une autre caractéristique de ce mode de réalisation, la pièce de couplage comprend une entretoise de montage entre la face de la zone de commande opposée à la face de commande, et le circuit imprimé.

Selon une caractéristique commune aux modes de réalisation, le revêtement élastique peut être translucide au moins en regard du trou traversant.

Selon une autre caractéristique commune aux modes de réalisation, le revêtement élastique peut présenter un pictogramme en regard du trou traversant.

Selon une autre caractéristique commune aux modes de réalisation, la courbe de résistance à l'enfoncement du revêtement élastique entre sa position de repos et sa position déformée comprend une rampe croissante de la position de repos jusqu'à une position intermédiaire et une rampe décroissante entre la position intermédiaire et la position déformée.

L'invention concerne également une pièce d'équipement intérieur de véhicule automobile comprenant un insert auto-portant, recouvert au moins partiellement par une peau souple, caractérisée en ce qu'elle comprend au moins un organe de commande tel que décrit ci-dessus.

L'insert auto-portant constitue au moins une zone de commande d'au moins un organe de commande.

La peau souple constitue le revêtement élastique non-conducteur recouvrant une face de commande d'au moins une zone de commande d'au moins un organe de commande.

Un premier avantage de la présente invention résulte de la butée en position déformée. Ainsi, l'utilisateur a une impression de geste abouti augmentant sa perception de commande.

Un autre avantage de la présente invention résulte de la continuité de matière solide entre l'électrode de détection tactile et le doigt de l'utilisateur en position déformée. En effet, les lignes de champs électriques, nécessaires à la détection tactile, sont sensibles au milieu dans lequel elles passent. En particulier, elles ont tendance à se disperser dans l'air. La continuité de matière a un effet de refocalisation des lignes de champs électriques permettant de réduire la puissance nécessaire à la détection. Ainsi, l'invention permet à l'utilisateur d'avoir une perception de commande sans pour autant augmenter la puissance nécessaire à la détection d'un système classique sans mouvement tel que décrit dans l'art antérieur.

D'autres avantages et caractéristiques de la présente invention résulteront de la description qui va suivre en référence aux dessins annexés dans lesquels:
- la figure 1 est une représentation schématique en coupe d'un organe de commande selon la présente invention dans la position de repos ;
- la figure 2 est une représentation de l'organe de commande selon la figure 1 en position déformée ;
- la figure 3 est une représentation schématique en coupe d'un organe de commande selon un autre mode de réalisation de la présente invention dans la position de repos ;
- la figure 4 est une représentation de l'organe de commande selon le mode de réalisation de la figure 3 en position déformée ;
- la figure 5 est une représentation schématique en coupe d'un autre mode de réalisation selon l'invention en position de repos ; et
- la figure 6 est une représentation schématique d'une courbe de la résistance à la déformation en fonction de la déformation, pour un organe de commande selon la figure 5.

La présente invention concerne un organe de commande de type capacitif 1 comprenant :
une structure de support 2 présentant une zone de commande 3, ladite zone de commande 3 comportant un trou traversant 4,
un revêtement élastique non-conducteur 5 recouvrant une face de commande 6 de la zone de commande 3 au moins en regard du trou traversant 4,
un détecteur tactile 7 au moins partiellement en regard du trou traversant 4 et monté sur ou à proximité de la face 8 de la zone de commande 3, opposée à la face de commande 6.

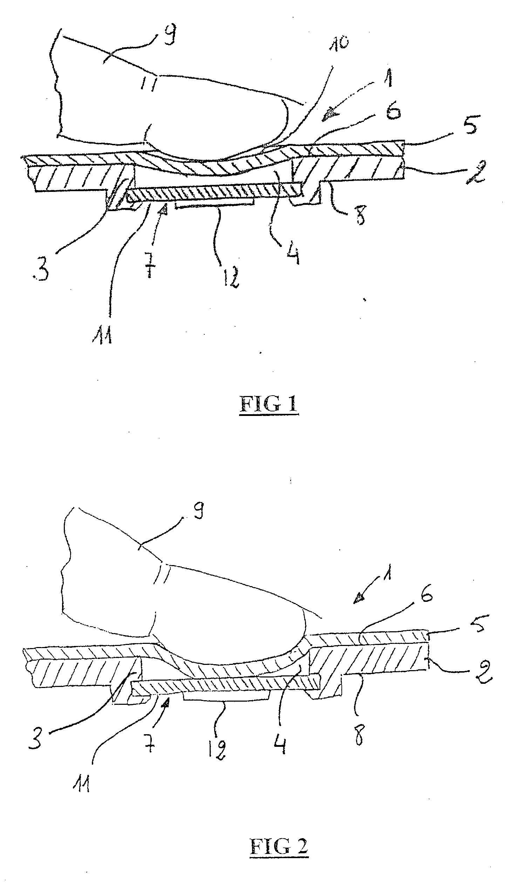

Le revêtement élastique 5 a une position de repos représenté figures 1, 3, et 5 dans laquelle le doigt 9 de l'opérateur au contact de la surface libre 10 du revêtement élastique 5 est hors de l'espace de détection tactile du détecteur 7, et une position déformée, dans laquelle le doigt 9 de l'opérateur au contact de la surface libre 10 du revêtement élastique 5 est dans l'espace de détection tactile du détecteur 7.

On entend par espace de détection tactile l'espace dans lequel le doigt 9 de l'opérateur génère une variation capacitive allant au-delà du seuil capacitif prédéterminé, déclenchant le signal de commande.

Selon l'invention, position de repos, le revêtement élastique 5 est écarté du détecteur tactile 7, et, position déformée, le revêtement élastique 5 est au contact du détecteur tactile 7.

Ainsi, pour que la commande soit activée, le doigt 9 de l'opérateur doit déformer le revêtement élastique jusqu'à la position déformée dans laquelle le revêtement élastique est au contact du détecteur tactile. Cela permet d'une part d'éviter les déclenchements de signaux de commande intempestifs par l'opérateur lorsqu'il effleure par inadvertance la zone de commande 3, et d'autre part de donner une impression de geste accompli à l'opérateur lorsque son doigt arrive en butée lors de l'activation de la commande.

Selon une caractéristique de la présente invention, le détecteur tactile 7 comprend un circuit imprimé 11 sur lequel est intégrée une électrode de détection tactile 12 au moins partiellement en regard du trou traversant 4.

Dans les formes de réalisation montrées sur les figures 1, 2 et 5, en position déformée, le revêtement élastique 5 est au contact direct du circuit imprimé 11.

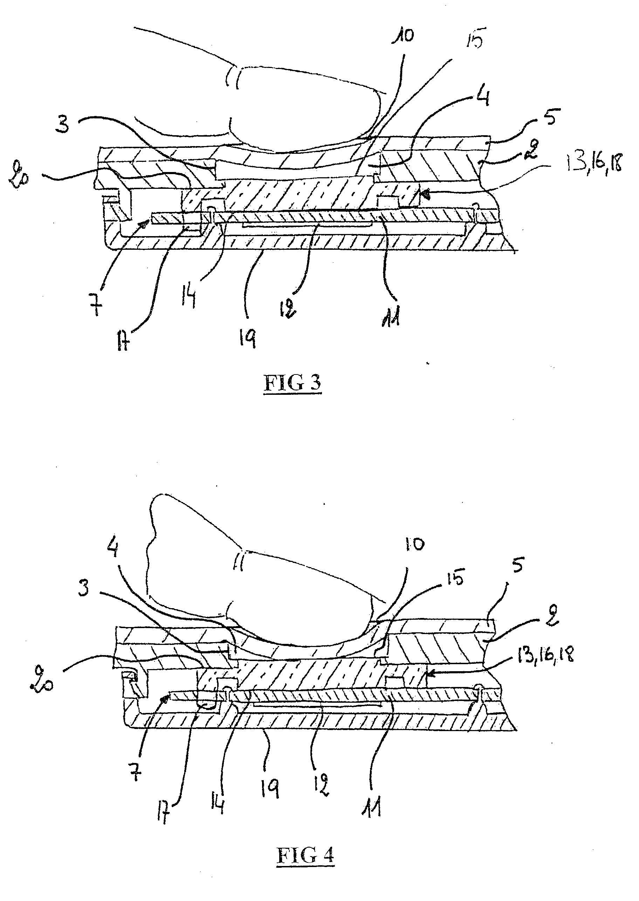

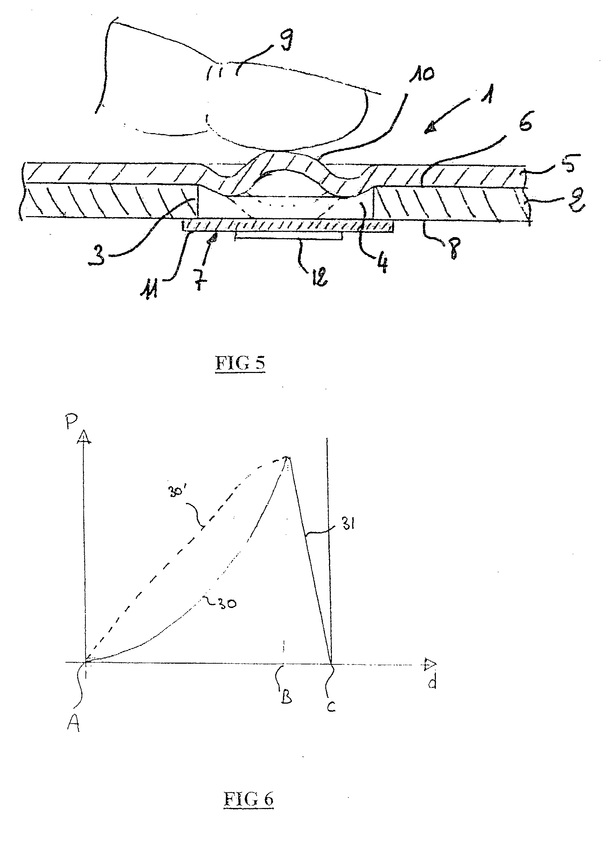

Dans la forme de réalisation représentée sur les figures 3 et 4, l'organe de commande comprend en outre une pièce de couplage 13 non-conductrice électriquement, au moins partiellement en regard du trou traversant 4 et de l'électrode 12, ayant une première face 14 montée au contact direct du circuit imprimé 11, et une seconde face 15 au contact direct du revêtement élastique 5 en position déformée.

Pour identifier la fonction commandée par l'organe de commande, le revêtement élastique 5 présente avantageusement un pictogramme (non représenté) en regard du trou traversant 4. Cela a pour but de bien identifier visuellement la zone de commande 3.

Toujours pour le même but, le revêtement élastique 5 présente une forme convexe et/ou concave en regard du trou traversant 4. Ainsi l'opérateur agissant en "aveugle" peut localiser plus facilement la zone de commande 3.

Avantageusement la pièce de couplage 13 comprend un guide de lumière 16 couplé avec au moins une source lumineuse 17. Cette source lumineuse 17 peut être intégrée sur le circuit imprimé 11.

Dans ce cas, le revêtement élastique 5 est au moins partiellement translucide au moins en regard du trou traversant 4. Ainsi, la zone de commande 3 peut être rétro-éclairée. Dans cette forme de réalisation, le pictogramme peut être disposé sur ou sous le revêtement élastique 5, ou, sur le guide de lumière 16.

Dans la forme de réalisation représentée sur les figures 3 et 4, la pièce de couplage 13 assure le rôle d'entretoise de montage 18 entre la face 8 de la zone de commande 3 opposée à la face de commande 6, et le circuit imprimé 11.

Le circuit imprimé 11 est monté sur un carter 19 rapporté sous la structure de support 2. La pièce de couplage 13 comprend des épaulements 20 venant porter sur la face 8 de la zone de commande 3 opposée à la face de commande 6. Cette fonction d'entretoise 18 contribue au respect de la distance minimum entre l'électrode 12 et la surface libre 10 du revêtement élastique 5 en position de repos permettant d'éviter les déclenchements intempestifs.

La figure 5 représente une forme de réalisation dans laquelle le revêtement élastique 5 en regard du trou traversant 4 présente une forme de type cloquant. La courbe de résistance P à l'enfoncement d du revêtement élastique 5 de type "cloquant" entre sa position de repos et sa position déformée comprend une rampe croissante 30, 30' de la position de repos A jusqu'à une position intermédiaire B et une rampe décroissante 31 entre la position intermédiaire B et la position déformée C telles que représentée en figure 6.

Cela a pour avantage de donner l'impression à l'opérateur d'avoir déclenché la commande au moment de l'inversion des rampes 30, 31. Entre la position de repos A et la position intermédiaire B, l'opérateur doit augmenter la pression P sur le revêtement élastique pour pouvoir en assurer la déformation d. Entre la position intermédiaire B et la position déformée C finale, la pression P nécessaire décroît fortement donnant l'impression à l'opérateur d'avoir basculé un interrupteur.

La forme du revêtement élastique 5 de la figure 5, alternant de façon concentrique une forme convexe et une forme concave, permet d'obtenir l'impression ci-dessus sans avoir de pièces mécaniques en mouvement.

L'invention concerne aussi une pièce d'équipement intérieur de véhicule automobile comprenant un insert auto-portant 2, recouvert au moins partiellement par une peau souple 5 et comprenant au moins un organe de commande 1 tel que décrit ci-dessus.

En particulier, l'insert auto-portant 2 peut avantageusement constituer au moins une zone de commande 3 d'au moins un organe de commande 1.

En outre, la peau souple 5 peut constituer le revêtement élastique 5 non-conducteur recouvrant une face de commande 6 d'au moins zone de commande 3 d'au moins un organe de commande 1.

Un exemple d'une telle pièce d'équipement automobile peut être une façade centrale de planche de bord ou un médaillon/accoudoir de portière ou encore une coiffe de planche de bord comprenant un insert injecté recouvert d'une peau souple, ledit insert étant pourvu d'au moins un trou traversant recouvert par la peau souple, et d'un un détecteur tactile pour commander une fonction quelconque.

## Revendications

1. Organe de commande de type capacitif comprenant :
une structure de support (2) présentant une zone de commande (3), ladite zone de commande (3) comportant un trou traversant (4),
un revêtement élastique (5) non-conducteur recouvrant une face de commande (6) de la zone de commande (3) au moins en regard du trou traversant (4),
un détecteur tactile (7) au moins partiellement en regard du trou traversant (4) et monté sur ou à proximité de la face (8) de la zone de commande (3), opposée à la face de commande (6),
le revêtement élastique (5) ayant une position de repos dans laquelle le doigt (9) de l'opérateur au contact de la surface libre (10) du revêtement élastique (5) est hors de l'espace de détection tactile du détecteur (7), et une position déformée, dans laquelle le doigt (9) de l'opérateur au contact de la surface libre (10) du revêtement élastique (5) est dans l'espace de détection tactile du détecteur (7),
**caractérisé en ce qu'**en position de repos le revêtement élastique (5) est écarté du détecteur tactile (7), et en position déformée, le revêtement élastique (5) est au contact du détecteur tactile (7).

2. Organe de commande selon la revendication 1 **caractérisé en ce que** le détecteur tactile (7) comprend un circuit imprimé (11) sur lequel est intégrée une électrode (12) de détection tactile au moins partiellement en regard du trou traversant (4), le revêtement élastique (5) en position déformée étant au contact direct du circuit imprimé (11).

3. Organe de commande selon la revendication 1 **caractérisé en ce que** le détecteur tactile (7) comprend un circuit imprimé (11) sur lequel est intégrée une électrode (12) de détection tactile au moins partiellement en regard du trou traversant (4), et une pièce de couplage (13) non-conductrice électriquement, au moins partiellement en regard du trou traversant (4) et de l'électrode (12), ayant une première face (14) montée au contact direct du circuit imprimé (11), et une seconde face (15) au contact direct du revêtement élastique (5) en position déformée.

4. Organe de commande selon la revendication 3 **caractérisé en ce que** la pièce de couplage (13) comprend un guide de lumière (16) couplé avec au moins une source lumineuse (17).

5. Organe de commande selon la revendication 3 ou 4 **caractérisé en ce que** la pièce de couplage (13) comprend une entretoise de montage(18) entre la face (8) de la zone de commande (3) opposée à la face de commande (6), et le circuit imprimé (11).

6. Organe de commande selon l'une quelconque des revendications précédentes **caractérisé en ce que** le revêtement élastique (5) est translucide au moins en regard du trou traversant (4).

7. Organe de commande selon l'une quelconque des revendications précédentes **caractérisé en ce que** le revêtement élastique (5) présente un pictogramme en regard du trou traversant (4).

8. Organe de commande selon l'une quelconque des revendications précédentes **caractérisé en ce que** le revêtement élastique (5) entre sa position de repos (A) et sa position déformée (C) a une courbe de résistance (P) à l'enfoncement (d) comprenant une rampe croissante(30, 30') de la position de repos (A) jusqu'à une position intermédiaire (B) et une rampe décroissante (31) entre la position intermédiaire (C) et la position déformée (D).

9. Pièce d'équipement intérieur de véhicule automobile comprenant un insert auto-portant (2), recouvert au moins partiellement par une peau souple (5), **caractérisée en ce qu'**elle comprend au moins un organe de commande (1) selon l'une quelconque des revendications 1 à 8.

10. Pièce d'équipement selon la revendication 9 **caractérisée en ce que** l'insert auto-portant (2) constitue au moins une zone de commande (3) d'au moins un organe de commande (1).

11. Pièce d'équipement selon la revendication 9 ou 10 **caractérisée en ce que** la peau souple (5) constitue le revêtement élastique (5) non-conducteur recouvrant une face de commande (6) d'au moins zone de commande (3) d'au moins un organe de commande (1).
